# EUROPÄISCHE PATENTSCHRIFT

(11) **EP 0 669 716 B1**
(45) Veröffentlichungstag und Bekanntmachung des Hinweises auf die Patenterteilung: **14.01.1998**
(21) Anmeldenummer: 95101394.5
(22) Anmeldetag: 02.02.1995
(51) Int. Cl.: H03K 5/01, H03K 5/08

(54) **Schaltung zum Bereitstellen eines Triggersignals**
Circuit for supplying a trigger signal
Circuit pour générer un signal de déclenchement

(30) Priorität: 28.02.1994 DE 9403299 U
(43) Veröffentlichungstag der Anmeldung: 30.08.1995
(73) Patentinhaber: ROBERT BOSCH GMBH, 70442 Stuttgart (DE)
(72) Erfinder: Kutteruf, Karl-Martin, Dipl.-Ing., (FH), D-73272 Neidlingen (DE)

(56) Entgegenhaltungen:
- DE-A- 2 823 279
- DE-A- 2 847 290
- DE-A- 4 123 699
- FR-A- 2 631 446
- US-A- 4 185 494

## Beschreibung

### Stand der Technik

Die Erfindung betrifft eine Schaltung zum Bereitstellen eines Triggersignals. Eine solche Schaltung enthält im allgemeinen eine Signalaufbereitung, beispielsweise einen Komparator, die aus einem Eingangssignal ein definiertes Triggersignal für eine nachfolgende Schaltung erzeugt. Ein Triggersignal wird erzeugt, wenn das Eingangssignal einen vorgegebenen Pegel, der auch variabel sein kann, übersteigt. Es kann nicht ausgeschlossen werden, daß Störsignalanteile im Eingangssignal zu einem ungewollten Erzeugen von Triggersignalen führt. Eine ordnungsgemäße Funktion der nachfolgenden, auf das Triggersignale angewiesene Schaltung, kann in diesen Fällen nicht mehr gewährleistet werden.

Der Erfindung liegt die Aufgabe zugrunde, eine Schaltung zum Bereitstellen eines Triggersignals anzugeben, die einer nachfolgenden Schaltung eine eindeutige Triggerung ermöglicht.

Die Aufgabe wird durch die im Hauptanspruch angegebenen Merkmale gelöst.

### Vorteile der Erfindung

Die erfindungsgemäße Schaltung zum Bereitstellen eines Triggersignals stellt an einem Triggersignalausgang Triggerimpulse bereit, die sich im Pegel unterscheiden. Die Schaltung enthält einen, ein erstes Schaltsignal abgebenden ersten Komparator, der ein Eingangssignal mit einem ersten Schwellenwert vergleicht und einen, ein zweites Schaltsignal abgebenden zweiten Komparator, der das Eingangssignal mit einem zweiten, höheren Schwellenwert vergleicht. Die beiden Schaltsignale werden am Triggersignalausgang zusammengeführt, wobei das erste und zweite Schaltsignal unterscheidbare Pegel vorgeben.

Die erfindungsgemäße Schaltung ermöglicht einer nachgeschalteten Auswerteschaltung, der das Triggersignal zugeführt ist, das Erkennen von Signalanteilen im Eingangssignal, die zunächst die erste Schwelle und anschließend noch die zweite Schwelle übersteigen. Signalanteile im Eingangssignal, beispielsweise Störsignalanteile, die lediglich die erste Schwelle übersteigen, können in der nachfolgenden Auswerteschaltung erkannt und beispielsweise unterdrückt werden.

Vorteilhafte Weiterbildungen und Ausgestaltungen der erfindungsgemäßen Schaltung zum Bereitstellen eines Triggersignals ergeben sich aus abhängigen Ansprüchen.

Eine erste Möglichkeit, die unterscheidbaren Signalpegel am Triggersignalausgang bereitzustellen, bietet eine Addition der beiden Schaltsignale. Eine vorteilhafte andere Möglichkeit sieht eine Differenzierung der Schaltsignale vor, wobei das Ergebnis der Differenzierung des einen Schaltsignals einen unterschiedlichen Impulspegel im Vergleich zum anderen Schaltsignal ergeben soll.

Die erfindungsgemäße Schaltung ist beispielsweise geeignet zum Bereitstellen eines Triggersignals aus einem Eingangssignal, das von einem piezoelektrischen Geber bereitgestellt wird. Solche Geber sind in Beschleunigungs- oder Drucksensoren enthalten. Eine bevorzugte Anwendung sieht einen derartigen Geber vor, der als Klemmgeber ausgebildet ist, welcher an einer Kraftstoffleitung einer Brennkraftmaschine anbringbar ist. Die erfindungsgemäße Schaltung ermöglicht die Bereitstellung eines Triggersignals aus dem vom Klemmgeber abgegebenen Signal, aus dem die nachfolgende Auswerteschaltung beispielsweise einen Kraftstofförderbeginn bei Dieselbrennkraftmaschinen erkennen kann.

Weitere vorteilhafte Weiterbildungen und Ausgestaltungen der erfindungsgemäßen Schaltung ergeben sich aus weiteren abhängigen Ansprüchen in Verbindung mit der folgenden Beschreibung.

### Zeichnung

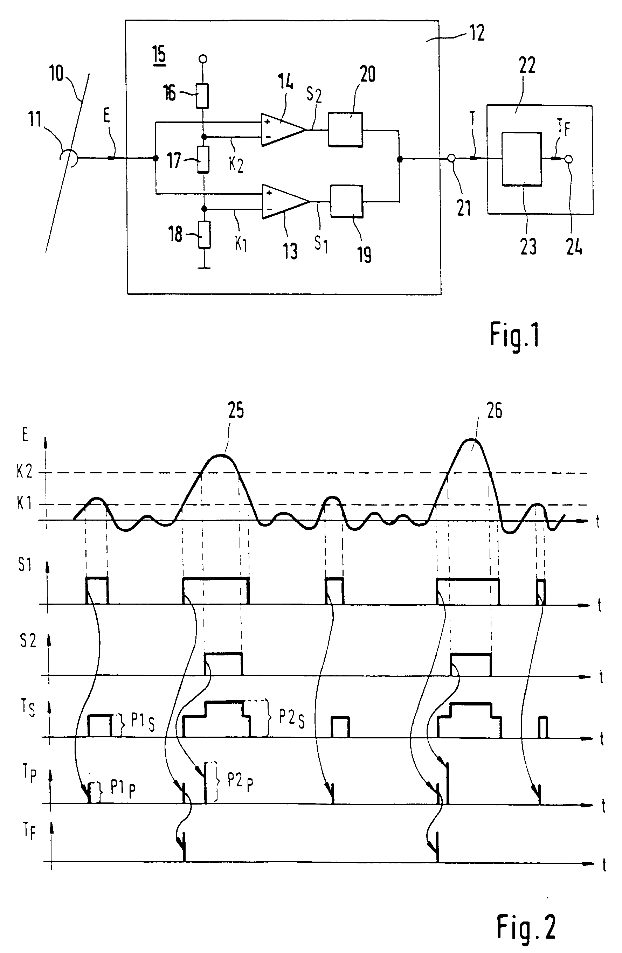

Figur 1 zeigt ein Blockschaltbild einer erfindungsgemäßen Schaltung zum Bereitstellen eines Triggersignals und Figur 2 zeigt Signalverläufe, die in dem Blockschaltbild gemäß Figur 1 auftreten.

Ein an einer Kraftstoffleitung 10 befestigter piezoelektrischer Klemmgeber 11 gibt ein Eingangssignal E an eine erfindungsgemäße Schaltung 12 zum Bereitstellen eines Triggersignals ab. Das Eingangssignal E gelangt jeweils auf einen nichtinvertierenden Eingang eines ersten und zweiten Komparators 13, 14. Die invertierenden Eingänge der Komparatoren 13, 14 sind jeweils an einer Spannungsteilerkette 15 angeschlossen, welche die Widerstände 16, 17, 18 enthält.

An der Spannungsteilerkette 15 werden Spannungen abgegriffen, die den Komparatoren 13, 14 als Schwellenwerte zugeführt sind. Zwischen den Widerständen 17, 18 tritt ein erster Schwellenwert K1 auf, der dem ersten Komparator 13 zugeführt ist, und zwischen den Widerständen 16, 17 tritt ein zweiter Schwellenwert K2 auf, der dem zweiten Komparator 14 zugeführt ist.

Der erste Komparator 13 gibt ein erstes Schaltsignal S1 und der zweite Komparator 14 ein zweites Schaltsignal S2 ab. Das erste Schaltsignal S1 gelangt in einen ersten Differenzierer 19 und das zweite Schaltsignal S2 wird in einem zweiten Differenzierer 20 weiterverarbeitet. Die beiden Ausgänge der Differenzierer 19, 20 sind zusammengeführt an einem Triggersignalausgang 21, an dem ein Triggersignal T abgreifbar ist.

Das Triggersignal T wird einer Auswerteschaltung 22 zugeführt, die ein Detektionsteil 23 enthält, das das Triggersignal T bearbeitet und in einem digitalen Speicher einen Zeitpunkt T_{F} festhält.

Figur 2 zeigt Signalverläufe in Abhängigkeit von der Zeit t, die in der erfindungsgemäßen Schaltung 12 zum Bereitstellen eines Triggersignals sowie in der Auswerteschaltung 22 auftreten.

Im ersten Teilbild von Figur 2 ist das vom Klemmgeber 11 abgegebene Eingangssignal E dargestellt. Eingetragen im ersten Teilbild sind der erste Schwellenwert K1 und der zweite Schwellenwert K2. Der zweite Schwellenwert K2 ist auf einen höheren Pegel festgelegt als der erste Schwellenwert K1. Das Eingangssignal E enthält zwei Signalanteile 25, 26, deren Pegel oder Amplitude sowohl den ersten Schwellenwert K1 als auch den zweiten Schwellenwert K2 übersteigt.

In den nächsten beiden Teilbildern von Figur 2 sind die von den Komparatoren 13, 14 abgegebenen Schaltsignale S1, S2 gezeigt.

Die beiden folgenden Signalverläufe geben Beispiele für das am Triggersignalausgang 21 bereitgestellte Triggersignal T wieder. Das erste Beispiel sieht als Triggersignal T die Bereitstellung eines stufenförmigen Triggersignals T_{S} vor, das aus der Addition des ersten und zweiten Schaltsignals S1, S2 hervorgeht. Der Pegel des stufenförmigen Triggersignals T_{S} nimmt zwei diskrete Werte P1_{S}, P2_{S} an, die aus einer Addition der beiden Schaltsignale S1, S2 hervorgehen. Anstelle des stufenförmigen Triggersignals T_{S} kann die Bereitstellung eines impulsförmigen Triggersignals T_{P} vorgesehen sein, das in dem nächsten Teilbild von Figur 2 gezeigt ist. Die impulsförmigen Signalanteile des impulsförmigen Triggersignals T_{P} entstehen durch eine Differenzierung der beiden Schaltsignale S1, S2, wobei im gezeigten Ausführungsbeispiel lediglich die positiven Impulse gezeigt sind, die durch Differenzieren der jeweils ansteigenden Signalflanken der Schaltsignale S1, S2 entstehen. Das impulsförmige Triggersignal T_{P} weist Impulse auf, die sich in ihrem Pegel unterscheiden. Beim Auftreten des ersten Schaltsignals S1 beträgt der Pegel P1_{P} und beim Auftreten des zweiten Schaltsignals S2 beträgt der Pegel P2_{P}.

Im letzten Teilbild von Figur 2 ist der Zeitpunkt T_{F} gezeigt, der identisch ist mit dem Auftreten des ersten Schaltsignals S1, dem unmittelbar ein Auftreten des zweiten Schaltsignals S2 folgt.

Die erfindungsgemäße Schaltung zum Bereitstellen eines Triggersignals gemäß Figur 1 wird anhand der in Figur 2 gezeigten Signalverläufe näher erläutert:

Die Schaltung 12 zum Bereitstellen eines Triggersignals ermittelt aus dem Eingangssignal E das Triggersignal T. Als Signalquelle ist beispielhaft ein piezoelektrischer Geber vorgesehen, der, ebenfalls beispielhaft, an die Kraftstoffleitung 10 geklemmt ist, die zur Kraftstoffversorgung einer Dieselbrennkraftmaschine vorgesehen ist. Der Klemmgeber 10 erfaßt die Druckschwankungen an der Kraftstoffleitung 10. Das vom Klemmgeber 11 abgegebene Signal ist in Figur 2 als Eingangssignal E wiedergegeben. Das Eingangssignal E enthält zwei Signalanteile 25, 26, deren Pegel jeweils sowohl den ersten Schwellenwert K1 als auch den zweiten Schwellenwert K2 übersteigen. Die Signalanteile 25, 26 entsprechen Förderimpulsen in der Kraftstoffleitung 10. Die Auswerteschaltung 22, vorzugsweise ein Motortester, benötigt beispielsweise den Beginn der Signalanteile 25, 26, die einem Förderbeginn einer in Figur 1 nicht näher gezeigten Dieseleinspritzpumpe gleichzusetzen sind. Ein Vergleich des Eingangssignals E mit lediglich einer Schwelle würde dazu führen, daß ungültige Triggerimpulse im Triggersignal T enthalten sind, die aufgrund von Störanteilen im Eingangssignal E enthalten sind. Erfindungsgemäß sind deshalb zunächst die beiden Schwellenwerte K1, K2 vorgesehen. Erfindungswesentlich ist weiterhin die Signalzusammenführung der beiden Schaltsignale S1, S2, an einem gemeinsamen Triggersignalausgang 21. Diese Maßnahme ermöglicht es, eine beispielsweise vorhandene Auswerteschaltung 22, die lediglich einen Triggereingang aufweist, zu verwenden. Die nachfolgende Auswerteschaltung 22 kann dann mit einfachen Mitteln in ihrem Detektionsteil 23 dem Triggersignal T entnehmen, wann das erste oder das zweite Schaltsignal S1, S2 aufgetreten ist, wenn dafür gesorgt wird, daß in Abhängigkeit von den Schaltsignalen S1, S2 unterschiedliche Signalpegel P1_{S}, P2_{S}; P1_{P}, P2_{P} im Triggersignal T auftreten.

Eine erste, einfache Möglichkeit sieht vor, daß ein stufenförmiges Triggersignal T_{S} als Triggersignal T bereitgestellt wird, das aus einer Addition der beiden Schaltsignale S1, S2 hervorgeht. Das stufenförmige Triggersignal T_{S} ist in Figur 2 gezeigt, wobei die beiden Pegel P1_{S}, P2_{S} unterschiedlich sind, weil das zweite Schaltsignal S2 stets nur dann auftreten kann, wenn das erste Schaltsignal S1 vorhanden ist. Die Addition ermöglicht deshalb stets die Bereitstellung der unterschiedlichen Pegel P1_{S}, P2_{S}.

Eine andere vorteilhafte Ausgestaltung sieht eine Differenzierung der beiden Schaltsignale S1, S2 vor, bevor sie am gemeinsamen Triggersignalausgang 21 zusammengeführt werden. Die Differenzierer 19, 20 sind beispielsweise mit einem Kondensator realisierbar, der mit einem in der Figur 1 nicht gezeigten Arbeitswiderstand eine Hochpaßfilterung vornimmt, die einer Differenzierung entspricht. Als Ergebnis wird ein impulsförmiges Triggersignal T_{P} als Triggersignal T am Triggersignalausgang 21 abgegeben. Das impulsförmige T_{P} ist in Figur 2 als vorletzter Signalverlauf eingetragen mit den beiden unterschiedlichen Pegeln P1_{P}, P2_{P}. Die Impulse mit dem Pegel P1_{P} sind von dem ersten Schaltsignal S1 abgeleitet, wobei lediglich die ansteigende Signalflanke des ersten Schaltsignals S1 berücksichtigt ist. Unter gleichen Voraussetzungen sind die Impulse des impulsförmigen Triggersignals T_{P} mit dem Pegel P2_{P} aus dem zweiten Schaltsignal S2 abgeleitet. Die unterschiedlichen Pegel P1_{P}, P2_{P} im impulsförmigen Triggersignal T_{P} können einerseits durch unterschiedliche Anstiegsgeschwindigkeiten der Schaltsignale S1, S2 und andererseits durch unterschiedliche Parametervorgaben bei der Differenzierung in den Differenzierern 19, 20 erreicht werden.

Das Detektionsteil 23 der Auswerteschaltung 22 erhält mit den unterschiedlichen Pegeln P1_{S}, P2_{S}; P1_{P}, P2_{P} des Triggersignals T die Möglichkeit, die Signalanteile 25, 26 zu detektieren mit der Besonderheit, daß der Beginn der Signalanteile 25, 26 ab dem Zeitpunkt, bei dem die Signalanteile 25, 26 den ersten Schwellenwert K1 übersteigen, detektierbar ist. Im beschriebenen Ausführungsbeispiel entspricht der Beginn der Signalanteile 25, 26 jeweils dem Förderbeginn einer Dieselkraftstoffeinspritzpumpe.

Das Detektionsteil 23 in der Auswerteschaltung 22 enthält geeignete Speicher, die das Triggersignal T, beispielsweise das stufenförmige Triggersignal T_{S} oder das impulsförmige Triggersignal T_{P} speichern. Wird der Triggersignalanteil mit dem Pegel P2_{S}, P2_{P} festgestellt, der vom Auftreten des zweiten Schaltsignals S2 verursacht ist, kann daraus geschlossen werden, daß das vorangegangene Auftreten des ersten Schaltsignals S1 dasjenige Ereignis ist, auf das zu triggern ist. Das Detektionsteil 23 speichert diesen Zeitpunkt als Steuersignal T_{F} ab, das im letzten Teilbild von Figur 2 gezeigt ist. Eine insbesondere digitale Signalverarbeitung mit Signalspeicherung ermöglicht den Rückgriff auf bereits vorhandene Signale, die vor dem Auftreten des zweiten Schaltsignals S2 vorhanden waren.

## Patentansprüche

1. Schaltung zum Bereitstellen eines Triggersignals, mit einem ein erstes Schaltsignal (S1) abgebenden ersten Komparator (13), der ein Eingangssignal (E) mit einem ersten Schwellenwert (K1) vergleicht, mit einem ein zweites Schaltsignal (S2) abgebenden zweiten Komparator (14), der das Eingangssignal (E) mit einem zweiten, höheren Schwellenwert (K2) vergleicht, mit einem Triggersignalausgang (21), an dem die beiden Schaltsignale (S1, S2) der Komparatoren (13, 14) zusammengeführt sind, wobei das erste und zweite Schaltsignal (S1, S2) unterscheidbare Pegel (P1_{S}, PS2_{S}; P1_{P}, P2_{P}) am Triggersignalausgang (21) vorgeben.

2. Schaltung nach Anspruch 1, bei der die Schaltsignale (S1, S2) nach einer Differenzierung in Differenzierern (19, 20) am Triggersignalausgang (21) zusammengeführt sind.

3. Schaltung nach Anspruch 1, bei der die Schaltsignale (S1, S2) am Triggersignalausgang (21) addiert sind.

4. Schaltung nach Anspruch 1, bei der das Eingangssignal (E) von einem piezoelektrischen Geber (11) bereitgestellt ist.

5. Schaltung nach Anspruch 4, mit einem als Klemmgeber ausgebildeten piezoelektrischen Geber (11), der an eine Kraftstoffleitung einer Brennkraftmaschine klemmbar ist.

6. Schaltung nach Anspruch 1 oder 4, mit einer am Triggersignalausgang (21) anschließbaren Auswerteschaltung (22), die ein Detektionsteil (23) enthält, welches das am Triggersignalausgang (21) abgreifbare Triggersignal (T, T_{S}, T_{P}) auf das Auftreten eines dem zweiten Schaltsignal (S2) zugeordneten Triggersignalpegels (P2_{S}, P2_{P}) überwacht und ein Steuersignal (T_{F}) speichert, wenn ein dem ersten Schaltsignal (S1) zugeordneter Pegel (P1_{S}, P1_{P}) aufgetreten ist, der von einem dem zweiten Schaltsignal (S2) zugeordneten Pegel (P2_{S}, P2_{P}) im Triggersignal (T, T_{S}, T_{P}) gefolgt ist.

7. Schaltung nach Anspruch 1, wobei die Schaltung (12) in einem Gehäuse angeordnet ist, dem das Eingangssignal (E) zuführbar ist und das den Triggersignalausgang (21) aufweist.

## Claims

1. Circuit for supplying a trigger signal, having a first comparator (13), which emits a first switching signal (S1) and compares an input signal (E) with a first threshold value (K1), having a second comparator (14), which emits a second switching signal (S2) and compares the input signal (E) with a second, higher threshold value (K2), and having a trigger-signal output (21), at which the two switching signals (S1, S2) of the comparators (13, 14) are brought together, the first and second switching signals (S1, S2) prescribing different levels (P1_{S}, PS2_{S}; P1_{P}, P2_{P}) at the trigger-signal output (21).

2. Circuit according to Claim 1, in which the switching signals (S1, S2) are brought together at the trigger-signal output (21) after differentiation in differentiating elements (19, 20).

3. Circuit according to Claim 1, in which the switching signals (S1, S2) are added at the trigger-signal output (21).

4. Circuit according to Claim 1, in which the input signal (E) is supplied by a piezoelectric sensor (11).

5. Circuit according to Claim 4, having a piezoelectric sensor (11) which is constructed as a clamping sensor which can be clamped onto a fuel line of an internal combustion engine.

6. Circuit according to Claim 1 or 4, having an evaluation circuit (22) which can be connected to the trigger-signal output (21) and contains a detecting section (23) which monitors the trigger signal (T, T_{S}, T_{P}), which can be tapped at the trigger-signal output (21), for the occurrence of a trigger-signal level (P2_{S}, P2_{P}) assigned to the second switching signal (S2), and stores a control signal (T_{F}) given the occurrence of a level (P1_{S}, P1_{P}) which is assigned to the first switching signal (S1) and is followed by a level (P2_{S}, P2_{P}) in the trigger signal (T, T_{S}, T_{P}) which is assigned to the second switching signal (S2).

7. Circuit according to Claim 1, the circuit (12) being arranged in a housing to which the input signal (E) can be fed and which has the trigger-signal output (21).

## Revendications

1. Circuit pour générer un signal de déclenchement, comprenant :
- un premier comparateur (13) fournissant un premier signal de commutation (S1) en comparant un signal d'entrée (E) à un premier seuil (K1),
- un second comparateur (14) fournissant un second signal de commutation (S2) en comparant le signal d'entrée (E) à un second seuil (K2) supérieur au précédent,
- une sortie de déclenchement (21) réunissant les deux signaux de commutation (S1, S2) des comparateurs (13, 14),
- le premier et le second signal de commutation (S1, S2) définissant des niveaux différents (P1_{S}, P2_{S} ; P1ₚ, P2ₚ) à la sortie de signal de déclenchement (21).

2. Circuit selon la revendication 1,
caractérisé en ce que
les signaux de commutation (S1, S2) sont réunis à la sortie (21) du signal de déclenchement après avoir été différentiés dans des différentiateurs (19, 20).

3. Circuit selon la revendication 1,
caractérisé en ce que
les signaux de commutation (S1, S2) sont additionnés à la sortie de déclenchement (21).

4. Circuit selon la revendication 1,
caractérisé en ce que
le signal d'entrée (E) est fourni par un capteur piézo-électrique (11).

5. Circuit selon la revendication 4,
caractérisé par
un capteur piézo-électrique (11) en forme de capteur de pincement qui est pincé sur une conduite de carburant d'un premier moteur à combustion interne.

6. Circuit selon l'une des revendications 1 ou 4, comprenant un circuit d'exploitation (22) relié à la sortie (21) du signal de déclenchement, ce circuit d'exploitation comportant un détecteur (23) qui surveille le signal de déclenchement (T, T_{S}, Tₚ) à la sortie (21) du signal de déclenchement, pour contrôler l'arrivée d'un niveau de signal de déclenchement (P2_{S}, P2ₚ) associé au second signal de commutation (S2), et pour enregistrer un signal de commande (T_{F}) lorsqu'un niveau (P1_{S}, P1ₚ) associé au premier signal de commutation (S1) est dépassé, et que celui-ci est suivi par un niveau (P2_{S}, P2ₚ) associé au second signal de commutation (S2) dans le signal de déclenchement (T, T_{S}, Tₚ).

7. Circuit selon la revendication 1,
caractérisé en ce que
le circuit (12) est logé dans boîtier recevant le signal d'entrée (E) et ayant une sortie (21) pour le signal de déclenchement.
